Europäisches Patentamt

European Patent Office

Office européen des brevets

(19)

(11) Numéro de publication: **0 220 974**
**B1**

## FASCICULE DE BREVET EUROPEEN

(12)

(45) Date de publication du fascicule du brevet:
03.01.90

(21) Numéro de dépôt: 86402033.4

(22) Date de dépôt: 17.09.86

(51) Int. Cl.⁴: **H01L 27/06**

(54) Composant semiconducteur de puissance et logique de commande associée.

(30) Priorité: 24.09.85 FR 8514137

(43) Date de publication de la demande:
06.05.87 Bulletin 87/19

(45) Mention de la délivrance du brevet:
03.01.90 Bulletin 90/1

(84) Etats contractants désignés:
DE FR GB IT NL

(56) Documents cités:
EP-A- 0 048 146
EP-A- 0 060 635
EP-A- 0 094 972

IBM TECHNICAL DISCLOSURE BULLETIN,
vol. 21, no. 2, juillet 1978, pages 677,678, New York, US;
F.A. PERNER et al.: "Power high voltage/low voltage
integrated circuit structure"
IEEE ELECTRON DEVICE LETTERS, vol.
EDL-5, no. 11, novembre 1984, pages 461-463, IEEE, New
York, US; B-Y. TSAUR et al.: "Merged CMOS/bipolar
technologies utilizing zone-melting-recrystallized SOI
films"
MACHINE DESIGN,
vol. 56, no. 24, 25 octobre 1984, pages 22-24,26, Cleveland, Ohio, US; B.H. CARLISLE: "Power integration
techniques bring single-chip relays"

(73) Titulaire: SGS-THOMSON MICROELECTRONICS S.A., 7,
Avenue Galliéni, F-94250 Gentilly(FR)

(72) Inventeur: Borel, Joseph Thomson - CSF SCPI,
19 avenue de Messine, F-75008 Paris(FR)

(74) Mandataire: Rinuy, Santarelli, 14, avenue de la Grande
Armée, F-75017 Paris(FR)

## Description

La présente invention concerne le domaine des composants semiconducteurs.

Il est fréquent que l'on ait besoin de commander des charges (lampes, moteurs) consommant une énergie importante (plusieurs watts à plusieurs dizaines de watts, voire plusieurs centaines de watts) et on utilise pour commander le passage du courant des composants semiconducteurs qui sont couramment des transistors bipolaires de puissance, des thyristors ou des triacs, des transistors à effet de champ de puissance, et aussi des associations de transistors (montages Darlington etc...)

Aujourd'hui on utilise des composants individuels comprenant essentiellement une pastille semiconductrice encapsulée dans un boîtier, et parfois deux pastilles semiconductrices (par exemple pour certains montages Darlington) encapsulées dans le même boîtier.

Ces composants de puissance doivent eux mêmes être commandés et ils le sont par des circuits de commande qui peuvent être constitués sur des cartes imprimées.

Dans un cas classique, on associera directement un composant de puissance monté dans un boîtier à un circuit intégré de commande, constitué sur une pastille semiconductrice montée dans un autre boîtier.

On cherche de plus en plus à réaliser des composants individuels incorporant le maximum de fonctions, par exemple ici le composant de puissance et son circuit intégré de commande.

Mais on se heurte vite à des difficultés importantes.

Par exemple, si on voulait incorporer la pastille de circuit intégré et la pastille de puissance dans un boîtier unique (comme on associe une pastille de transistor et une autre pastille de transistor pour faire un montage Darlington en boîtier unique), on s'aperçoit que les technologies de montage ne sont pas du tout les mêmes a priori pour les circuits intégrés et pour les composants de puissance.

Ou alors, si on veut essayer d'intégrer le composant de puissance et un circuit de commande logique sur la même pastille semiconductrice, on se heurte à des difficultés de fabrication (incompatibilités des technologies de circuit intégré et des technologies de composants de puissance) ou tout simplement à des difficultés de fonctionnement électrique de l'une ou l'autre des parties de la pastille ; ces difficultés de fonctionnement électrique proviennent soit du fait qu'il est difficile d'optimiser les conditions de fabrication de la partie circuit intégré en même temps que celles de la partie puissance ; soit surtout du fait que le composant de puissance engendre, lorsqu'il fonctionne, des perturbations importantes sur le circuit intégré de commande ; en effet, non seulement le circuit intégré de commande et le composant de puissance sont à proximité immédiate, mais ils sont même placés sur un substrat commun dans lequel diffusent largement les porteurs (électrons ou trous) qui s'accumulent lors de la conduction du composant de puissance. De l'article de B.J. TSAUR et al publié dans "IEEE Electron Devi-ces Letters" vol. EDL-5, no 11 (1984.11), pages 461–463 est connue une structure semiconductrice où des dispositif CMOS sont réalisés sur le même substrat que des transistors bipolaires verticaux sont en étant totalement isolés électriquement. Les dispositif CMOS sont disposés dans une couche de Si recristallisée sur une couche de $SiO_2$ réalisée sur une partie d'un substrat de Si alors que le transistor bipolaire est réalisé dans une couche épitaxiale de Si déposé sélectivement sur les parties exposés dudit substrat.

La présente invention propose une solution pour permettre dans les meilleures conditions une association sur une même pastille d'un composant de puissance fonctionnant sous une tension relativement basse (quelques volts à quelques dizaines de volts) mais avec des courants élevés (plusieurs ampères à plusieurs dizaines d'ampères) et d'un circuit intégré de commande de ce composant de puissance.

On réalise le composant de puissance sur une première partie d'un substrat semiconducteur, avec une première métallisation principale sur la face avant du substrat, une deuxième métallisation principale sur la face arrière, et, sur la face avant, un moyen de commande de la conduction de courant entre les métallisations principales ; selon l'invention, dans une deuxième partie du substrat, on forme sur la face avant une couche isolante revêtue d'une couche semiconductrice formée par dépôt et recristallisation de matériau semiconducteur polycristallin ou amorphe, cette couche n'étant pas en contact avec le semiconducteur du substrat, et les circuits de commande étant intégrés dans cette couche semiconductrice ; ces circuits sont reliés d'une part au moyen de commande du composant de puissance, constitué sur la première partie du substrat, et d'autre part à des plots de connexion permettant de connecter la structure à des broches de connexion extérieures dans un montage en boîtier de composant de puissance multibroches.

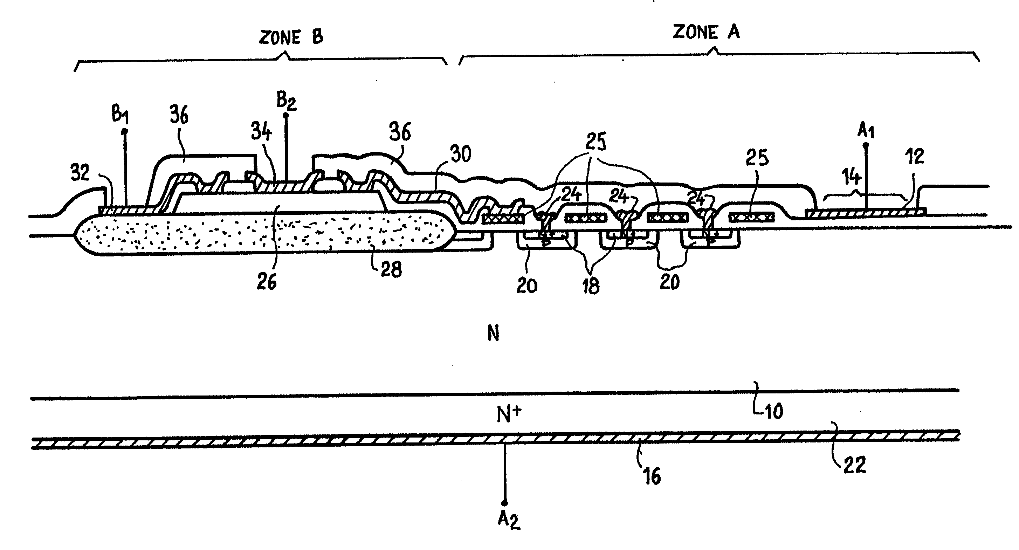

D'autres caractéristiques et avantages de l'invention apparaîtront à la lecture de la description détaillée qui suit et qui est faite en référence au dessin annexé dans lequel la figure unique représente en coupe la structure semiconductrice selon un exemple de réalisation de la présente invention.

La figure est dessinée de manière à représenter les éléments essentiels de la structure selon l'invention constituée à partir d'un substrat semiconducteur monocristallin 10.

Cette structure comporte deux parties ; la première partie, désignée par l'appellation zone A, est située sur la partie droite de la figure ; la deuxième partie, zone B, est située sur la partie gauche de la figure.

Dans la pratique la deuxième partie peut être localisée vers le centre de la pastille ou au contraire vers la périphérie. Elle peut aussi être constituée de plusieurs portions séparées.

La zone A est celle qui contient le composant de puissance. Ce composant est destiné à conduire un courant de quelques ampères à quelques dizaines d'ampères entre une première électrode principale A1 et une deuxième électrode principale A2.

La première électrode principale se présente sous forme d'une métallisation 12 située sur la face avant du substrat, cette métallisation étant dénudée partiellement ou totalement pour constituer un plot de connexion pouvant être relié électriquement à une broche extérieure lors du montage en boîtier. L'emplacement de ce plot est désigné par la référence 14.

La deuxième électrode principale est une métallisation 16 située sur la face arrière du substrat et couvre en principe toute cette face. Elle est totalement ou quasi-totalement dénudée pour que, lors du montage en boîtier, le substrat puisse être soudé par sa face arrière sur une embase métallique non représentée ; cette embase sert à l'amenée de courant à l'électrode A2 du côté de la face arrière.

Le composant de puissance comporte naturellement, à l'intérieur du substrat, un certain nombre de couches semiconductrices de types de conduction variés permettant son fonctionnement en interrupteur de courant commandé, et il comporte un moyen de commande de cet interrupteur, c'est-à-dire un moyen de commande du passage du courant entre les électrodes principales A1 et A2.

Par exemple, si le composant de puissance est un thyristor ou un triac (quatre couches semiconductrices alternées NPNP), le moyen de commande est une électrode de gâchette reliée à une couche de type P ; si le composant est un transistor bipolaire ou un montage Darlington, le moyen de commande est en principe la base du transistor.

Sur la figure, on a représenté schématiquement comme composant de puissance un transistor MOS vertical à canal diffusé, dont les régions de source et de drains sont interdigitées.

Les régions de source 18 sont des régions de type N$^+$ diffusées à la surface supérieure à l'intérieur de régions de canal 20 de type P également diffusées, plus profondes et plus larges que les régions de source. Les régions de canal sont espacées les unes des autres et séparées par des régions de drain de type N constituées par le corps du substrat. La partie inférieure 22 du substrat est de type N$^+$ pour permettre un bon contact avec la métallisation 16 de face arrière. Les régions de source sont de préférence métallisées (métallisations 24 reliées au plot de connexion 14 de la première électrode principale A1). On pourrait aussi avoir plusieurs composants de puissance avant une même électrode principale de face arrière A2 et des électrodes et plots de connexion différents sur la face avant.

Le transistor comporte enfin une grille conductrice 25 en peigne, qui est isolée du substrat et qui recouvre les régions de canal pour en contrôler la conduction.

La constitution d'un tel transistor est classique et n'a pas besoin d'être décrite en détail étant donné que de nombreuses réalisations sont possibles avec des technologies différentes des unes des autres.

Le moyen de commande de conduction est alors constitué par la grille 25 en peigne.

La zone B est celle qui contient un circuit intégré de commande du composant de puissance. Ce circuit peut comporter un nombre élevé de composants individuels (transistors à effet de champ notamment ou transistors bipolaires). Mais il n'est pas formé directement dans le substrat semiconducteur 10.

Il est formé dans une couche semiconductrice 26 totalement séparée du substrat par une couche isolante 28. Ce qu'on entend par couche totalement isolée signifie simplement que la couche semiconductrice proprement dite est déposée sur la couche isolante sans toucher le substrat semiconducteur lui-même. Mais bien entendu la couche semiconductrice n'est pas totalement isolée dans le sens où des composants sont formés dans cette couche pour former un circuit et au moins la sortie de ce circuit est reliée par une interconnexion en principe électrique (mais elle pourrait être optique) au moyen de commande du composant de puissance situé sur le substrat.

La couche isolante 28 est déposée ou formée d'une autre manière (oxydation thermique localisée si le substrat est en silicium) à la surface du substrat sur la face avant. Son épaisseur peut être de 1 micromètre environ.

La couche semiconductrice 26 est déposée uniformément sur la face avant.

Cette couche semiconductrice est monocristalline ; elle est obtenue en principe par dépôt de matériau semiconducteur sous une forme polycristalline ou amorphe ; dans ce cas elle est ensuite recristallisée de manière à devenir monocristalline. Son épaisseur peut être de 0,5 micromètre à plusieurs dizaines de micromètres selon les applications. La recristallisation peut être faite par laser ou lampe ; elle consiste à faire fondre localement la couche et à déplacer progresivement la zone fondue sur toute la région à recristalliser ; la zone fondue se recristallise en refroidissant ; on commence par exemple par recristalliser la couche là où elle est en contact direct avec le substrat monocristallin (en dehors de la zone isolante 28) puis on déplace la zone fondue au dessus de la couche isolante 28. De toutes façons il est préférable que la largeur de la couche 28 ne soit pas supérieure à 40 micromètres pour faciliter la recristallisation. Plusieurs zones de couche 28 peuvent bien entendu être prévues.

Des détails sur les procédés de recristallisation de couches semiconductrices amorphes ou monocristallines peuvent être trouvés dans la revue RCA Review Vol 44 page 266, Juin 1983.

Après recristallisation, la couche semiconductrice 26 est gravée pour ne laisser subsister de zones recristallisées que sur la couche 28 ou les ilots de couche 28 ou en tous cas pour séparer complètement du substrat une portion de couche 26 reposant sur l'isolant 28.

Le circuit intégré de commande est formé dans la couche semiconductrice 26 avec toutes les opérations nécessaires à cela : diffusions d'impuretés de types N et P (bore, phosphore), oxydations, dépôts de substances variées (nitrure de silicium, oxyde de silicium, silicium polycristallin, aluminium etc...), gravures sélectives des dépôts effectués etc...

Le circuit intégré de commande formé dans la couche semiconductrice 26 est relié au moyen de commande du composant de puissance. C'est pourquoi on a représenté, dans le cas le plus simple, un conducteur de liaison 30 en contact d'un côté avec une partie du circuit intégré de commande (par exemple en contact avec le drain d'un transistor à effet de champ d'un étage de sortie du circuit), et un contact de l'autre côté avec la grille en peigne 25 du transistor MOS vertical de puissance.

Si le composant de puissance était un transistor bipolaire (ou un montage Darlington à deux ou trois transistors avec un transistor pilote), la connexion conductrice venant du circuit intégré de commande pourrait aboutir directement sur le substrat semiconducteur 10, dans une région diffusée de base du transistor (du transistor pilote pour un montage Darlington). De même, pour un thyristor, on ferait aboutir la connexion dans la région de gâchette.

Par ailleurs le circuit intégré de commande doit, pour réaliser la fonction pour laquelle il est prévu, être alimenté en énergie et recevoir des signaux d'entrée et il doit être correctement référencé par rapport à la masse du composant de puissance. Par exemple, le circuit intégré analyse les signaux reçus d'un capteur et décide en fonction de ces signaux s'il y a lieu de faire conduire ou non le composant de puissance.

Par conséquent la structure une fois montée en boitier aura des broches de connexion pour la réception de l'énergie et des signaux nécessaires aux fonctionnement du circuit de commande. Ces broches sont reliées à des plots de connexion de la même manière qu'une broche est connectée à la métallisation 12 de face avant du composant de puissance.

Contrairement au montage classique de circuits intégrés dans lesquels on soude des fils d'or ou d'aluminium très fins (de l'ordre d'un micron de diamètre) d'un côté sur des plots de connexion de la pastille et de l'autre sur des broches extérieures, on choisira de préférence ici pour relier le circuit intégré de commande à l'extérieur un type de montage normalement utilisé uniquement pour des composants de puissance ; en particulier on utilisera pour chacune de ces connexions comme pour la connexion du plot 14 un montage avec une broche rigide dont une extrémité vient s'appliquer directement (pour y être soudée) sur un plot métallisé formé sur la face avant de la structure et dont l'autre extrémité constitue une broche de connexion extérieure une fois le composant mis en boitier. C'est surtout en choisissant pour les plots 32, 34, une surface suffisante (qui ne serait pas nécessaire a priori pour un circuit intégré classique) que ce montage devient possible.

A titre d'exemple on a représenté sur la figure deux plots de connexion pour le circuit intégré, pour constituer deux connexions extérieures B1 et B2. Les métallisations correspondantes, 32 et 34, reliées à des éléments du circuit intégré, peuvent être formées soit sur la couche semiconductrice 26 elle-même, soit sur un isolant interposé entre la couche 26 et la métallisation, soit encore sur un isolant interposé entre le substrat 10 et la métallisation (par exemple sur la couche isolante 28 elle-même).

Pour les puissances les moins élevées du composant de puissance (moins de 1 ampère) on pourra se contenter d'un montage à fils conducteurs épais (50 microns de diamètre) reliés entre les plots de connexion de la face avant et les broches extérieures.

L'ensemble de la face avant de la structure est passivé par une couche isolante 36 à l'exception des plots de connexion extérieure.

Avec ce type d'association du circuit intégré de commande et du composant de puissance on peut optimiser les caractéristiques du composant de puissance (densité de courant admissible, courant ou tension de commande, tenue en tension inverse etc...), sans que cela réagisse d'une manière défavorable sur le circuit de commande. En effet, les diffusions profondes du composant de puissance (surtout s'il s'agit d'un thyristor) seront faites avant formation de la couche isolante 28 et de la couche semiconductrice 26. Les diffusions superficielles du composant de puissance (par exemple les régions de source et de canal du transistor MOS vertical) pourront être également faites avant, mais alors en prenant soin d'effectuer les oxydations et diffusions du circuit de commande à des températures n'excédant pas 800 à 900 °C pour qu'elles n'altèrent pas sensiblement les profondeurs de diffusion du composant de puissance. Les diffusions superficielles du composant de puissance pourront également être faites en même temps que les diffusions du circuit de commande dans les cas où ces dernières sont compatibles avec les profondeurs de diffusion choisies pour optimiser le composant de puissance.

La transmission des signaux de commande du circuit intégré de commande vers le composant de puissance pourra se faire d'une manière particulièrement avantageuse par une liaison découplée galvaniquement, c'est-à-dire une liaison n'impliquant pas un transfert de charges électriques entre la couche monocristalline du circuit de commande et le substrat du composant de puissance. Par exemple une liaison capacitive peut être prévue, mais aussi une liaison optique utilisant à son profit la transparence de la couche isolant 28 : une jonction photoémissive formée dans la couche 26 servirait à émettre un signal de commande optique. Les photons traverseraient la couche isolante 28 et seraient recueillis par un composant photodétecteur (photodiode, photo transistor etc...) dans le substrat au-dessous dela jonction photo-émissive. Ce type de transmission réduit d'autant mieux les perturbations pouvant être apportées au circuit de commande par les charges électriques accumulées dans les couches du composant de puissance.

**Revendications**

1. Structure semiconductrice associant un composant de puissance à un circuit de commande, l'ensemble étant formé sur un substrat semiconducteur monocristallin, le composant de puissance comportant une première métallisation principale (A1) sur une face avant du substrat, une deuxième métallisation principale (A2) sur une face arrière, et, sur la face avant, un moyen de commande de la conduction du courant entre les métallisations principales, caractérisée en ce que le circuit de commande est un circuit intégré formé dans une couche semiconductrice (26) formée par dépôt et recristallisation de matériau semiconducteur polycristallin ou amorphe, la couche semiconductrice étant formée sur une couche isolante (28) recouvrant une partie du substrat, et cette couche semiconductrice n'étant pas en contact avec le semiconducteur du substrat, le circuit de commande étant relié d'une part au moyen de commande du composant de puissance et étant relié par ailleurs à des plots de connexion permettant de connecter la structure à des broches de connexion extérieures lorsqu'elle est montée dans un boîtier de composant de puissance à plusieurs broches.

2. Structure semiconductrice selon la revendication 1 caractérisée en ce que les plots de connexion sont adaptés à une connexion par soudure d'une extrémité de broche conductrice dont une autre extrémité constitue une broche de connexion extérieure d'un boîtier incorporant la structure.

3. Structure selon la revendication 1, caractérisé en ce que le circuit intégré de commande est relié au moyen de commande du composant de puissance par une liaison non galvanique.

4. Structure selon la revendication 3, caractérisée en ce que la liaison non galvanique est une liaison optique à travers la couche isolante (28).

**Patentansprüche**

1. Halbleiterstruktur, die einen Leistungsteil einer Steuerschaltung zuordnet, wobei die gesamte Anordnung auf einem monokristallinen Halbleitersubstrat ausgebildet ist und der Leistungsteil eine erste Hauptmetallisierung (A1) auf einer vorderen Fläche des Substrates, eine zweite Hauptmetallisierung (A2) auf einer hinteren Fläche und auf der vorderen Fläche eine Steuereinrichtung für die Stromleitung zwischen den Hauptmetallisierungen umfaßt, dadurch gekennzeichnet, daß die Steuerschaltung eine integrierte Schaltung ist, die in einer Halbleiterschicht (26) ausgebildet ist, die durch Abscheidung und Rekristallisation eines polykristallinen oder amorphen Halbleitermaterials gebildet ist, wobei die Halbleiterschicht auf einer isolierenden Schicht (28) ausgebildet ist, die einen Teil des Substrates überdeckt, und wobei diese Halbleiterschicht mit dem Halbleiter des Substrates nicht in Kontakt steht, und daß die Steuerschaltung einerseits mit der Steuereinrichtung des Leistungsteils und andererseits mit Anschlußkontakten verbunden ist, die es ermöglichen, die Struktur mit äußeren Kontaktstiften zu verbinden, wenn sie in einem Gehäuse für ein Leistungsbauelement mit mehreren Stiften montiert wird.

2. Halbleiterstruktur nach Anspruch 1, dadurch gekennzeichnet, daß die Anschlußkontakte für eine Schweiß- oder Lötverbindung mit dem einen Ende des Kontaktstiftes ausgebildet sind, dessen anderes Ende einen äußeren Kontaktstift eines die Struktur enthaltenden Gehäuses bildet.

3. Halbleiterstruktur nach Anspruch 1, dadurch gekennzeichnet, daß die integrierte Steuerschaltung mit der Steuereinrichtung des Leistungsbauelementes durch eine nicht galvanische Verbindung verbunden ist.

4. Halbleiterstruktur nach Anspruch 3, dadurch gekennzeichnet, daß die nicht galvanische Verbindung eine optische Verbindung durch die isolierende Schicht (28) hindurch ist.

**Claims**

1. A semiconductor structure associating a power component with a control circuit, the assembly being formed on a monocrystalline semiconductor substrate, the power component comprising a first principal metallization (A1) on one front face of the substrate, a second principal metallization (A2) on a rear face and, on the front face, a means for controlling the conduction of current between the principal metallizations, characterized in that the control circuit is an integrated circuit formed in a semiconducting layer (26) which is formed by deposition and recrystallization of polycrystalline or amorphous semiconductor material, the semiconducting layer being formed on an insulating layer (28) which covers a part of the substrate, and this semiconducting layer not being in contact with the semiconductor of the substrate, the control circuit being connected on the one hand to the means for controlling the power component and also being connected to terminal connections permitting the structure to be connected to external connection contacts when it is mounted in a power component casing comprising several contacts.

2. A semiconductor structure according to claim 1, characterized in that the connection terminals are adapted for connection by soldering to an end of a conducting contact, the other end of which constitutes an external connection contact of a casing incorporating the structure.

3. A structure according to claim 1, characterized in that the integrated control circuit is connected to the means for controlling the power component by a non galvanic connection.

4. A structure according to claim 3, characterized in that the non galvanic connection is an optical connection across the insulating layer (28).

ZONE B  ZONE A

$B_1$ 36 $B_2$ 34 36 30 25 25 $A_1$ 12

32 24 24 24 14

26 28 20 18 20

N

$N^+$ 10

16 22

$A_2$

EP 0 220 974 B1